# EUROPEAN PATENT APPLICATION

(11) **EP 2 924 722 A1**
(43) Date of publication of application: **30.09.2015**
(21) Application number: 15160738.9
(22) Date of filing: 25.03.2015
(51) Int. Cl.: H01L 21/762

(54) **Method for manufacturing a semiconductor-on-insulator device**

(30) Priority: 28.03.2014 EP 14162317
(71) Applicant: IMEC VZW, 3001 Leuven (BE)
(72) Inventor: Waldron, Niamh, 3001 Leuven (BE)
(74) Representative: Clerix, André

(57) **Abstract**

A method for manufacturing semiconductor-on-insulator devices is disclosed. The method comprises providing a pre-patterned donor wafer, providing a handling wafer and bonding the pre-patterned donor wafer to the handling wafer by contacting the first oxide layer to the handling wafer. Providing a pre-patterned donor wafer comprises providing a donor substrate comprising a first semiconductor material; forming shallow trench isolation (STI) regions in the donor substrate; forming fins in the donor substrate in between the STI regions, the fins comprising a Group III-V or Group IV semiconductor material (different from the first semiconducting material), the fins extending from the donor substrate in between the STI regions; providing an first oxide layer overlying the STI regions and the fins. After bonding the donor wafer to the handling wafer at least part of the first semiconducting material of the pre-patterned donor wafer is removed and the STI regions and the fins are thinned thereby forming channel regions comprising the Group III-V or Group IV semiconductor material.

## Description

### Technical field

The present disclosure relates to methods for manufacturing semiconductor-on-insulator devices. It relates more particularly to a method for manufacturing semiconductor-on-insulator devices with a channel region comprising a group III-V or a group IV material.

The present disclosure also relates to a semiconductor-on-insulator wafer suitable for manufacturing such semiconductor-on-insulator devices.

The present disclosure also relates to a donor wafer for manufacturing a semiconductor-on-insulator wafer and associated semiconductor-on-insulator devices.

### Background art

Semiconductor industry is considering materials other than silicon (Si) in order to guarantee improved performance and to set the pace for the next technology nodes. Possible candidates to replace Si as active channel material are germanium (Ge) and III-V materials. To be competitive, III-V materials should be monolithically integrated with Si, in order to benefit from the existing Si-based semiconductor processing. The use of Si as a substrate would also enable the integration of several functional blocks on the same platform, such as for example logic, high-frequency, and I/O circuitry.

The integration of III-V on a Si platform is however challenging due to all sorts of crystalline defects as for instance lattice mismatch, anti-phase boundaries, mismatch stress relaxation, threading dislocations, stacking faults, etc..

The III-V on insulator (III-V-OI) technology is also emerging as a promising technology for advanced CMOS applications for 1x nm technology node and beyond.

The formation of such III-V-OI structures can for instance be done using methods as disclosed by Takagi et al in the article "III-V-on-Insulator MOSFETs on Si substrates fabricated by direct wafer bonding" in ECS Transactions, 33 (4) p.359-370 (2010). A first method involves direct growth of III-V materials on Si substrates. This method has the disadvantage of using thick buffer layers (in the order of 1 µm and more) in order to keep the crystal quality of the III-V layer as high as possible and the defect level at the interface as low as possible. The use of thick buffer layers (also often referred to strain relaxed buffer (SRB) layers) is moreover very expensive. A second method is known as direct wafer bonding (DWB). An InGaAs layer is thereby formed on a 2 inch InP donor wafer. A buried oxide (BOX) layer of SiO₂ is then deposited on the InGaAs/InP. The SiO₂/InGaAs/InP wafer is then bonded in air to a Si handling wafer. The InP donor wafer is thereafter removed resulting in a III-V-OI on Si substrate wafer which may be further processed.

This method has the disadvantage that the use of 2 inch III-V donor wafers is not a feasible solution for the 1x nm technology node and beyond. Moreover 2 inch III-V donor wafers are expensive.

### Summary of the disclosure

It is an aim of the present disclosure to provide a method for manufacturing semiconductor-on-insulator devices.

It is an aim of the present disclosure to provide a semiconductor-on-insulator wafer and a method for manufacturing such a semiconductor-on-insulator wafer. The semiconductor-on-insulator wafer from the present disclosure may be used for manufacturing semiconductor-on-insulator devices.

It is an aim of the present disclosure to provide a donor wafer for manufacturing a semiconductor-on-insulator wafer and more specifically for manufacturing semiconductor-on-insulator devices.

This aim is achieved according to the disclosure with a method showing the technical characteristics of the independent claims.

According to a **first aspect** of the present invention, a method for manufacturing semiconductor-on-insulator devices is disclosed. The method comprises providing a pre-patterned donor wafer, which preferably comprises the steps of providing a donor substrate comprising a first semiconductor material; forming shallow trench isolation (STI) regions in the donor substrate; forming fins (also referred to as fin structures) in the donor substrate in between the STI regions, the fins comprising a Group III-V or a Group IV semiconductor material (both different from the first semiconducting material), the fins extending from the donor substrate separated by and in between the STI regions. The pre-patterned donor wafer thus preferably comprises a donor substrate, STI regions or structures provided on the donor substrate, and fins in between the STI regions, the fins comprising a Group III-V or a Group IV semiconductor material (both different from the first semiconducting material), the fins extending from the donor substrate separated by and in between the STI regions. The method further comprises providing a first oxide layer overlying the STI regions and the fins; providing a handling wafer; bonding the (front side of the) pre-patterned donor wafer to the handling wafer by contacting the oxide layer to the handling wafer; removing (e.g. comprising thinning (e.g. parallel thinning) and/or etching) at least part of the first semiconductor material of the pre-patterned donor wafer (from its back side) and, preferably thereafter, thinning the STI regions and the fins thereby forming channel regions comprising the Group III-V or Group IV semiconductor material.

According to embodiments of the first aspect the fins are formed by replacing at least part of the first semiconductor material of the donor substrate in between the STI regions by the Group III-V or the Group IV semiconductor material. The first semiconductor material in between the STI regions may thus be removed partially (not reaching the depth of the STI structures) or completely (reaching the full depth of the STI structures). Removing the first semiconductor material is preferably done by etching. The group III-V or the Group IV semiconductor material is preferably provided by epitaxial growth in between the STI regions starting from the first semiconductor material. The mechanism of replacing the first semiconductor material into the Group III-V or the Group IV semiconductor material is also generally known as aspect ratio trapping (ART) technique. The replacing is preferably a regrowth of the protrusions in the trenches in between the STI structures. The aspect ratio trapping effects reduced the formation of defects during such a regrowth process.

According to embodiments of the first aspect, the remaining STI regions may be removed after forming the channel regions.

According to embodiments of the first aspect, providing a handling wafer comprises providing a handling substrate comprising a second semiconductor material and providing another, a second oxide layer on the handling substrate. Bonding then preferably comprises bonding the first oxide layer to the second oxide layer.

Both the donor substrate and the handling substrate preferably comprise silicon (Si), but other for the skilled person suitable materials can be used.

The donor substrate is preferably a blanket Si wafer, but other for the skilled person suitable substrates can be used.

The handling substrate is preferably chosen from a blanket or patterned Si wafer, a blanket or patterned Ge wafer, a blanket or patterned SOI wafer, a blanket or patterned germanium-on-silicon wafer, or a blanket or patterned GeOI wafer.

According to embodiments of the first aspect the donor wafer and the handling wafer have a wafer size of at least 300mm.

The first oxide layer and the second oxide layer are preferably chosen from an insulating metal oxide (e.g. Al2O3, HfO2), an insulating dielectric layer (e.g. SiO, SiN), or an insulating wide bandgap semiconductor (e.g. AIN). In preferred embodiments, the first oxide layer is an Al2O3 layer and the second oxide layer is a SiO2 layer.

According to embodiments of the first aspect, removing at least part of the first semiconductor material of the pre-patterned donor wafer is done from the back side of the pre-patterned donor wafer.

According to embodiments of the first aspect, removing the donor substrate of the pre-patterned donor wafer may comprise a first (rough or non-selective; e.g. based on planar thinning technique) removal step followed by a second (selective; e.g. based on selective etch) removal step. The first removal step can remove the first semiconductor material of the donor substrate below the STI regions (i.e. remaining at a level above the STI structures, without reaching or affecting the STI structures) at the backside of the pre-patterned donor wafer). The second removal step removes the remaining first semiconductor material of the semiconductor substrate, including at least a portion in between the STI regions, if present (i.e. of the fins).

The removal step preferably comprises a thinning step by means of a planar thinning technology/technique. The removal step may further comprise an etching step to remove the remaining material of the donor substrate (Si substrate), selective with respect to the STI structures and the group III-V or the group IV material.

According to embodiments of the first aspect, the STI regions are formed by patterning the donor substrate thereby forming STI trenches and providing a dielectric material in the STI trenches. The dielectric material may be provided using state of the art deposition techniques. The dielectric material preferably comprises an oxide, e.g. SiO2.

According to embodiments of the first aspect, the Group III-V semiconductor material is chosen from InP, InGaAs, InAs, GaAs, or GaAsSb. The Group IV semiconductor material is chosen from Ge or SiGe.

According to alternative embodiments of the first aspect, removing the donor substrate of the pre-patterned donor wafer may be done by hydrogen release implantation, which involves the implantation of hydrogen to a predetermined depth into the pre-patterned donor wafer before the step of bonding and thereafter releasing the donor substrate of the pre-patterned donor wafer at the predetermined depth of the hydrogen implantation, by for instance applying an anneal step (this process if known to the skilled person as process of the "smartcut" type). The anneal step can be performed only at the stage that the donor substrate is removed. The predetermined depth may be below the STI regions (i.e. remaining at a level above the STI structures, without reaching or affecting the STI structures) or may be (at a level) within the STI regions.

According to embodiments of the first aspect, thinning the STI regions and the fins is done simultaneously by chemical mechanical polishing (CMP).

According to embodiments, the fins have a defectivity level less than 10⁹ defects/cm², more preferably less than 10⁶ defects/ cm².

According to embodiments, the upper portions of the fins (the portion originally most removed from the donor substrate; or the portion near the first oxide layer) have a defectivity level less than 10⁹ defects/cm², more preferably less than 10⁶ defects/ cm².

According to a **second aspect** of the present disclosure, a pre-patterned donor wafer for manufacturing a semiconductor-on-insulator device is disclosed, comprising a donor substrate comprising a first semiconductor material; a pattern of shallow trench isolation (STI) regions and fins on the donor substrate; the fins being separated by and located in between the STI regions; the fins comprising at least an upper part of a Group III-V or Group IV semiconductor material being different of the first semiconductor material, and a first oxide layer overlying the pattern.

According to embodiments, the donor substrate is a blanket Si wafer. The donor substrate preferably has a wafer size of at least 300mm.

According to embodiments, the Group III-V semiconductor material is preferably chosen from InP, InGaAs, InAs, GaAs, or GaAsSb.

According to embodiments, the Group III-V semiconductor material is chosen from InP, GaAs, InAs, AlAs, GaSb, AlSb, InSb and all ternary and quaternary combinations thereof.

The Group IV semiconductor material is preferably chosen from Ge or SiGe.

According to embodiments, the at least upper part of the fins (the portion adjacent to the first oxide layer) has a defectivity level less than 10⁹ defects/cm², more preferably less than 10⁶ defects/ cm². This portion can preferably serve as a channel structure/layer for a semiconductor device.

According to embodiments, a bottom part (e.g. the portion away from the first oxide layer) of the fins comprises the first semiconductor material.

According to embodiments, the fins further comprise below the upper part, and above the bottom part (or in between the upper part and the bottom part) another Group III-V or Group IV semiconductor material.

According to embodiments, the first oxide layer comprises an insulating metal oxide, an insulating dielectric layer, or an insulating wide bandgap semiconductor. The first oxide layer is preferably chosen from an insulating metal oxide (e.g. Al2O3, HfO2), an insulating dielectric layer (e.g. SiO, SiN), or an insulating wide bandgap semiconductor (e.g. AIN).

According to a **third aspect** of the present disclosure, a semiconductor-on-insulator wafer is disclosed, comprising a semiconductor substrate, an oxide layer on the substrate and a pattern of fins and STI regions or structures on the (then buried) oxide layer, the fins comprising a Group III-V or a Group IV semiconductor material different from the semiconductor substrate, the fins being in between, e.g. separated by and located in between, the STI regions or structures.

According to embodiments, the semiconductor-on-insulator wafer has a wafer size of 300mm or larger. Preferably the semiconductor substrate is a Si-based substrate.

According to embodiments, the Group III-V semiconductor material is chosen from InP, InGaAs, InAs, GaAs, or GaAsSb.

According to embodiments, the Group III-V semiconductor material is chosen from InP, GaAs, InAs, AlAs, GaSb, AlSb, InSb and all ternary and quaternary combinations thereof.

According to embodiments, the Group IV semiconductor material is chosen from Ge or SiGe.

According to embodiments, the oxide layer comprises insulating metal oxide, an insulating dielectric layer, an insulating wide bandgap semiconductor. The oxide layer can comprise a plurality of oxide layers. It can for instance be a bilayer of a first oxide layer, attached/adjacent to the fins, and a second oxide layer at the other side of the first oxide layer, the second oxide layer separating the first oxide layer from the semiconductor substrate. The first oxide layer and the second oxide layer are preferably chosen from an insulating metal oxide (e.g. Al2O3, HfO2), an insulating dielectric layer (e.g. SiO, SiN), or an insulating wide bandgap semiconductor (e.g. AIN). In preferred embodiments, the first oxide layer is an Al2O3 layer and the second oxide layer is a SiO2 layer.

According to embodiments, the fins have a defectivity level less than 10⁹ defects/cm², more preferably less than 10⁶ defects/cm².

According to embodiments, the upper portions of the fins (the portion near the first oxide layer) have a defectivity level less than 10⁹ defects/cm², more preferably less than 10⁶ defects/ cm².

It is an advantage of embodiments of the present disclosure that III-V-based semiconductor device may be formed with defect-free active channel region or at least a III-V-based semiconductor device with reduced defects in the active channel region, i.e. defect level less than 10⁹ defects/cm², more preferably less than 10⁶ defects/ cm².

It is an advantage of embodiments of the present disclosure that III-V-OI on Si semiconductor devices may be manufactured using a full wafer approach, i.e. using wafer of at least 300mm (also referred to as '12 inch') wafer size.

It is an advantage of embodiments of the present disclosure that manufacturing costs are reduced since a III-V-OI wafer of at least 300mm is provided. By using pre-patterned donor wafers (using ART process for manufacturing thereof), thinner layers are grown (i.e. layers thinner than 300nm or smaller), only on certain areas of the wafer thereby substantially reducing costs compared to prior art techniques where III-V material has to be provided over the whole wafer.

It is an advantage of embodiments of the present disclosure that III-V materials may be integrated on Si monolithically using Si wafers as handling and device wafer without the use of expensive and small III-V wafers and/or without the use of expensive and thick strain relaxed buffer (SRB)-based substrates. It is thus an advantage of embodiments of the present disclosure that the method for forming III-V-OI on Si semiconductor devices is less expensive than methods as known for a person skilled in the art.

It is an advantage of embodiments of the present disclosure that III-V semiconductor device may be provided with a better electrostatic control and Vt control by substrate voltage.

It is an advantage of embodiments of the present disclosure that co-integration of different semiconductor materials on a single wafer is possible.

### Brief description of the drawings

The disclosure will be further elucidated by means of the following description and the appended figures.

The drawings described are only schematic and are non-limiting. In the drawings, the size of some of the elements may be exaggerated and not drawn on scale for illustrative purposes. The dimensions and the relative dimensions do not necessarily correspond to actual reductions to practice of the disclosure.

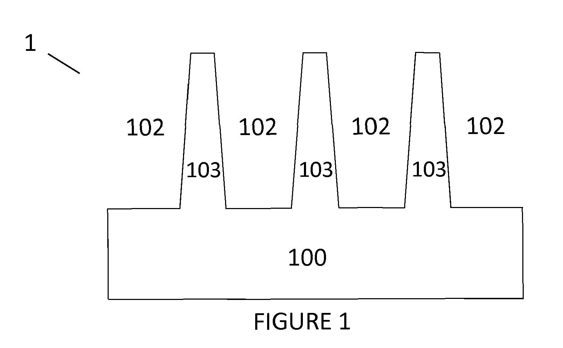

Figures 1 to 13 illustrate different process steps for a method of manufacturing semiconductor-on-insulator devices according to the present disclosure.

### Detailed description of preferred embodiments

The present disclosure will be described with respect to particular embodiments and with reference to certain drawings but the disclosure is not limited thereto but only by the claims.

Furthermore, the terms first, second, third and the like in the description and in the claims, are used for distinguishing between similar elements and not necessarily for describing a sequential or chronological order. The terms are interchangeable under appropriate circumstances and the embodiments of the disclosure can operate in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the disclosure described herein can operate in other orientations than described or illustrated herein.

Furthermore, the various embodiments, although referred to as "preferred" are to be construed as exemple manners in which the disclosure may be implemented rather than as limiting the scope of the disclosure.

According to a first aspect of the present invention, illustrated in Fig. 1 to 13, a method for manufacturing semiconductor-on-insulator devices 3 is disclosed.

Fig. 1 to Fig. 4 schematically illustrate different process steps according to embodiments of the present disclosure for providing a pre-patterned donor wafer 1. The technique used to provide a pre-patterned donor wafer preferably makes use of the technique known to the skilled person as aspect ratio trapping (ART). Aspect ratio trapping involves high aspect ratio sub-micron trenches to trap threading dislocations, greatly reducing the dislocation density of lattice mismatched materials grown on silicon.

First a semiconductor substrate 100 is provided. The semiconductor substrate is a donor substrate comprising a first semiconductor material. The semiconductor substrate 100 is preferably a Si-based substrate. The semiconductor substrate 100 is a wafer with wafer size of at least 300mm (also referred to as a 12 inch wafer). Also larger wafer sizes may be used for the donor substrate, such as for example 450mm wafers (also often referred to as 18 inch wafer).

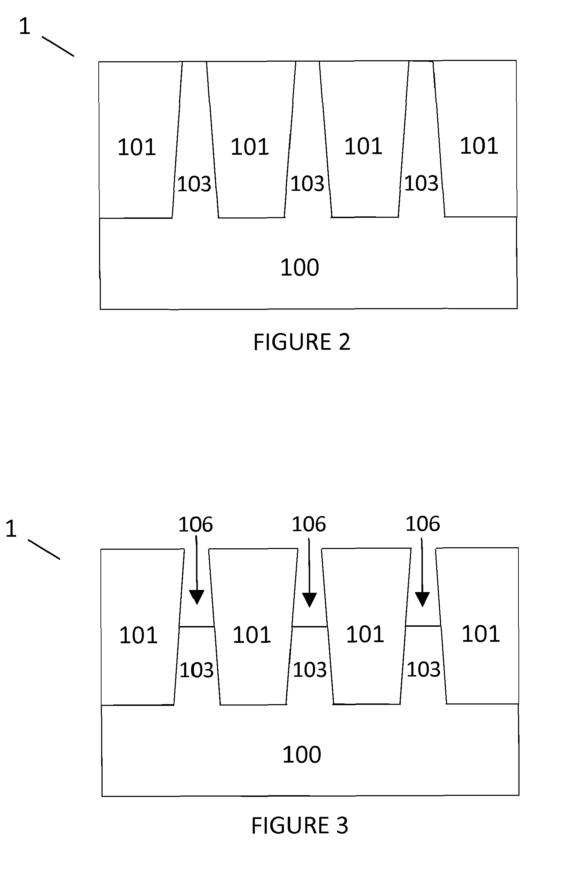

Shallow trench isolation (STI) regions 101 are provided in the donor substrate 100 (Fig. 2). The STI regions 101 may be between 100nm and 500nm deep and may have a width ranging from 500nm down to 20nm. For more advanced STI modules the depth of the STI region can even be below 100nm and the width of the STI region can be down to 5nm. As a rule of thumb, the aspect ratio (it is the ratio between the depth and the width) of the STI regions should be at least 2. Providing the STI regions 101 may be done by techniques known by a person skilled in the art. For instance in may include lithographic patterning the semiconductor substrate 100, etching the semiconductor substrate 100 (Fig. 1) and thereafter filling the etched regions 102 with an insulating material such as for example an oxide (for example SiO₂)(Fig. 2).

After providing the STI regions 101, fins or lines 103 of the first semiconductor material of the donor substrate 100 are present in between the STI regions 101. These semiconductor fins or lines 103 have a height equal to the height of the STI regions 101 and a width ranged from 100 nm down to 20nm or even down to 5 nm. As a rule of thumb, the aspect ratio (it is the ratio between the depth and the width) of the fins should be at least 2. The semiconductor fins or lines 103 are elongated and lying in a same plane as the semiconductor substrate surface. The length of the semiconductor fins or lines may be several nm's, preferably much larger than the width of the fin, for example 10 times larger. A pattern of STI regions and fins or lines is thus provided in the donor substrate, wherein the fins or lines are in between the STI regions and as such separated or isolated from each other. Such a structure with semiconductor fins or lines in between and isolated by STI regions is also often referred to as a STI template structure.

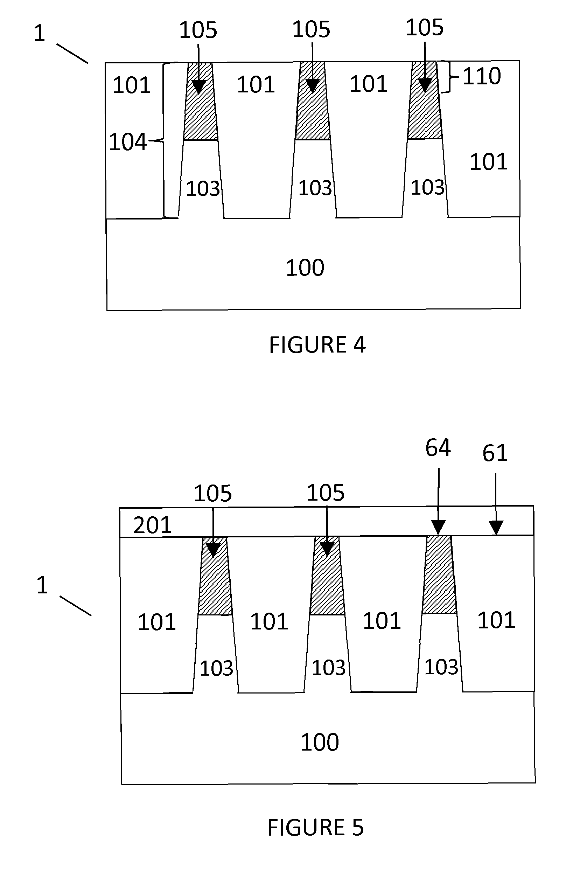

After providing the STI regions 101 (and semiconductor fins 103) at least part of the remaining first semiconductor material in between the STI regions 101 is replaced by a Group III-V or Group IV semiconductor material 105 (Fig. 3, Fig. 4). The Group III-V or Group IV semiconductor material 105 is chosen to be different as the initial first semiconductor material. As such fins 104 are formed on the semiconductor substrate 100 in between the STI regions 101, the fins 104 comprising another semiconductor material 105 than the first semiconductor material 103 of the semiconductor substrate (Fig. 3). For example, InP fins may be provided on a Si substrate.

Replacing the first semiconductor material may be done by at least partly removing the first semiconductor material in between the STI regions 101 thereby creating cavities 106 between the STI regions 101. The fins are thus recessed leaving cavities or recesses 106. These cavities 106 may then be filled again with a second semiconductor material 105, more specifically a Group III-V or Group IV semiconductor material. The cavities 106 may also be filled with different Group III-V or Group IV semiconductor materials such as for example a bilayer of InGaAs/InP.

At least some of the cavities may be filled with a first Group III-V or Group IV semiconductor material and at least some of the cavities may be filled with a second Group III-V or Group IV semiconductor material (which is different from the first Group III-V or Group IV semiconductor material). For example some of the recesses may be filled with InP, whereas some other recesses may be filled with Ge. As such co-integration of different semiconductor materials is possible wherein the InP fins may be used for a first type of semiconductor device (NMOS) and the Ge fins may be used for a second type of semiconductor device (PMOS).

Removing the first semiconductor material of the fins is preferably done by etching. Filling the recesses with the group III-V or group IV material is then preferably done by epitaxial growth starting from the exposed semiconductor material of the donor substrate using ART.

The fins 104 in between the STI regions 101 preferably have an aspect ratio which is higher than 2. By increasing the aspect ratio of the fins 104 the quality of the second semiconductor material is enhanced. More specifically the higher the aspect ratio of the fins 104 the lower the defect density at the top part of the fins 104.

The top surface 61 of the STI regions and the top surface 64 of the final trenches/fin structures is substantially equal, i.e. at the same height level. The fins 104 and the STI regions 101 are thus abutting on a common top surface 61.

For example, the donor substrate may be a Si-substrate. SiO₂ STI regions may be formed in the Si-substrate. At least part of the Si in between the STI regions may be replaced by InP. This may be done by etching at least part of the Si in between the STI regions and thereafter epitaxially growing InP in the etched regions on the semiconductor substrate using ART.

The top part of the fins 104 can serve as the active regions or channel regions 110 of the final semiconductor-on-insulator devices. These are the regions/portions of the fins which have the lowest defect density. The defectivity level is below 10⁹ defects/cm², more preferably below 10⁶ defects/cm².

An (first) oxide layer 201 is then provided on the pre-patterned donor wafer 1, i.e. on the top surface of the STI regions 101 and the final trenches 104 / fins (103,105) (Fig. 5). The first oxide layer 201 may be an insulating metal oxide (e.g. Al2O3, HfO2), an insulating dielectric layer (e.g. SiO, SiN) or an insulating wide bandgap semiconductor (e.g. AIN).

The first oxide layer 201 may be a bilayer for example an Al2O3/SiO bilayer wherein the Al2O3 layer serves to create a good interface with the channel regions and wherein the SiO serves to facilitate a better bonding with the handle wafer. The first oxide layer 201 should have a minimum thickness of about 2 to 3 nm such that the layer is closed and thus completely covering the underlying STI regions and fins. The maximum thickness of the bonding layer is depending on the device requirements and may be up to 100nm. The oxide layer can serve as a buried oxide layer (BOX layer) of the final semiconductor-on-insulator devices.

The fins 104 may be passivated (such as for example using sulfur) before providing the (first) oxide layer 201. This may be done to improve the electrical interface between the pre-patterned donor wafer 1 and the oxide layer 201.

The first oxide layer 201 may be provided by deposition techniques known by a person skilled in the art such as for example chemical vapour deposition (CVD) or atomic layer deposition (ALD).

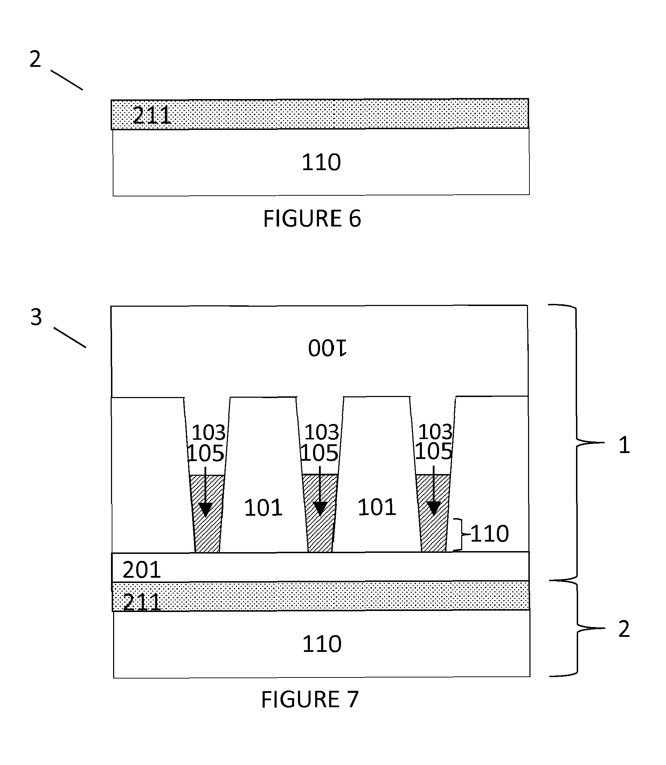

A handling wafer 2 is also provided comprising a semiconductor substrate and may optionally also comprise a second oxide layer 211 on top of the semiconductor substrate (Fig. 6).

The second oxide layer 211 has the same or similar requirements as the first oxide layer and may be identical to the first oxide layer 201 (on the pre-patterned donor wafer 1). After bonding the pre-patterned donor wafer to the bonding wafer an interface (such as for example an interfacial oxide) may be present in between the first oxide layer and the second oxide layer.

The semiconductor substrate of the handling wafer 2 is preferably a Si-based substrate. The handling wafer 2 preferably has a wafer size of at least 300mm is used. Also bigger wafer sizes may be used, such as for example 450mm wafers (also referred to as 18 inch wafers).

The handling wafer 2 can be for example be a blanket Si wafer, a previously patterned Si wafer with Si active and/or Ge, SiGe active regions or can be for example a Ge-on-Si (patterned or blanket) wafer or a Ge-OI on Si (patterned or blanket) wafer.

The pre-patterned donor wafer 1 is bonded to the handling wafer 2 by contacting the oxide layer 201 of the pre-patterned donor wafer 1 to the handling wafer 2 or, if present, to the second oxide layer 211 on the handling wafer 2 (Fig. 7).

After bonding the front side of the pre-patterned donor wafer 1 to the handling wafer 2 (or the second oxide on the handling wafer), the pre-patterned donor wafer 1 is released which means the first semiconductor material 103 of the semiconductor substrate of the pre-patterned donor wafer 1 is removed. This may be done in a number of ways.

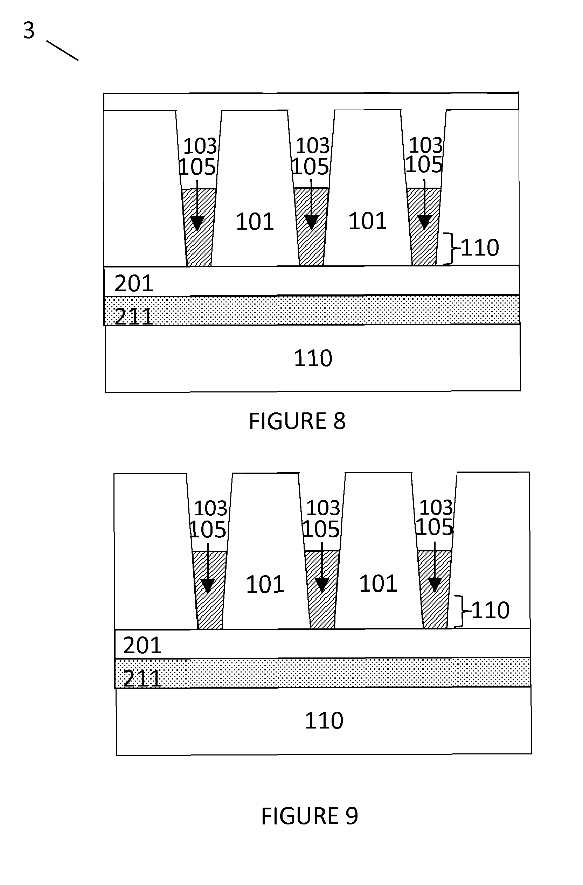

The release of the pre-patterned donor wafer 1 may be comprise a first (non-selective, e.g. by planar thinning process) removal step (Fig. 8) and a second (selective, e.g. by selective etching process) removal step (Fig. 9). In the first removal step the semiconductor substrate is removed at the backside of the wafer which is present below the STI regions 101. This may be done for example by grinding. In the second removal step the remaining semiconductor substrate is removed which is (possibly) present between the STI regions 101 in the fins 104. This may be done for example by wet etching (e.g. TMAH).

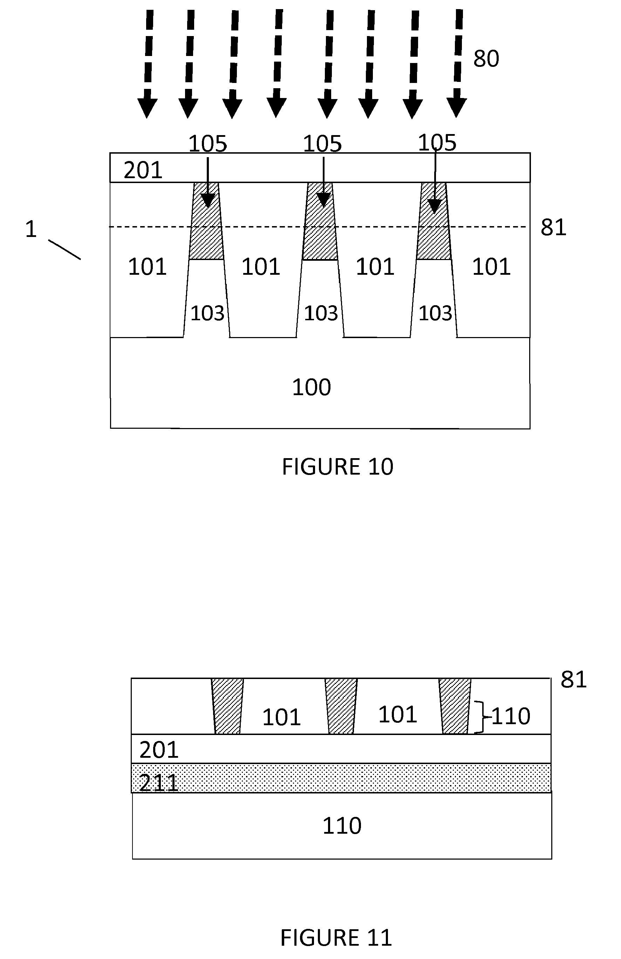

An alternative method to release the pre-patterned donor wafer 1 is by using a hydrogen (H) release implant. This process involves H₂ implantation 80 of the donor wafer to a predetermined depth 81 before the bonding step (Fig. 10). The predetermined depth 81 may be below the STI regions or may be in the STI regions. The depth of the H implant determines where the separation of the pre-patterned donor wafer occurs (Fig. 11), when suitable annealed in a later step of the process at a time that the donor substrate is removed. The separation may thus occur in the semiconductor material (Si) underneath the STI regions or directly in the STI regions itself. In the latter case there is only the STI material and the Group III-V or Group IV material remaining after the release.

If the separation occurs in the semiconductor material, the remainder of the semiconductor material (in the trenches) also needs to be removed. This may be done by selective etching.

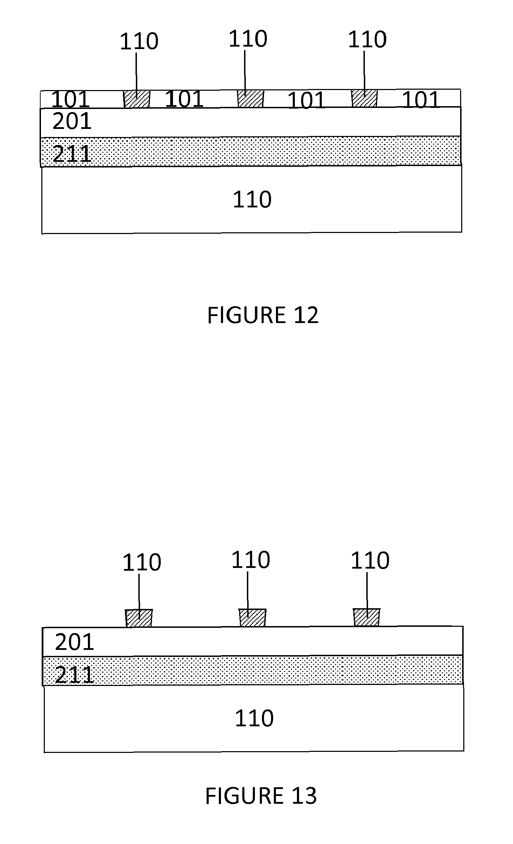

After releasing the pre-patterned donor wafer, the remaining Group III-V or Group IV fins are thinned to the desired thickness, i.e. the Group III-V or Group IV material in the fins is removed until that part is exposed which will serve as the active channel regions in the final semiconductor-on-insulator device (Fig. 12). This can for instance be done by chemical mechanical polishing (CMP). Preferably a CMP process is used that uses a slurry which is non-selectiveto (i.e. is etching equally fast) the STI material and the Group III-V or the Group IV material.

The etching rate of the STI material and of the Group III-V or Group IV semiconductor material is preferably the same.

If a single layer has been originally grown in the trench, the CMP step will determine the final thickness of the channel region. If a bilayer was grown, e.g. InGaAs on InP, then the CMP can be stopped in the InP layer. The so-called buffer (i.e. InP) may be removed selectively by (wet) etching. In this way the thickness of the channel region is determined by its original thickness in the starting STI template wafer.

The remaining STI material from the STI regions 101 may optionally also be removed after thinning the final trenches (Fig. 13).

The STI material may also be kept to serve as an isolation layer and to maintain a planar surface.

As the active channel regions are now formed, further processing steps may be performed as known for a person skilled in the art to manufacture a semiconductor-on-insulator device, such as providing a gate stack, providing source/drain regions, providing contacting,etc.

According to aspects of the present disclosure, a semiconductor-on-insulator wafer suitable for manufacturing semiconductor-on-insulator devices is disclosed. More specifically a wafer with a wafer size of at least 300mm or higher is disclosed comprising a group III-V or Group IV semiconductor material as active layer.

Therefore a pre-patterned donor wafer for bonding is disclosed, the donor wafer having also a wafer size of at least 300mm or higher and comprising a patterned structure of trenches comprising the Group III-V or Group IV semiconductor material in between STI region. This is preferably achieved using aspect ratio trapping (ART).

According to a second aspect of the present disclosure, a pre-patterned donor wafer for manufacturing a semiconductor-on-insulator device is disclosed comprising
- a donor substrate comprising a first semiconductor material;
- a pattern of shallow trench isolation (STI) regions and fins on the donor substrate; the fins being separated by and located in between the STI regions; the fins comprising at least an upper part of a Group III-V or a Group IV semiconductor material being different of the first semiconductor material, and
an oxide layer overlying the pattern (See Fig. 5).

According to a third aspect of the present disclosure, a semiconductor-on-insulator wafer is disclosed, comprising a semiconductor substrate, an oxide layer on the substrate and a pattern of fins and STI regions or structures on the oxide layer, the fins comprising a Group III-V or a Group IV semiconductor material different from the semiconductor substrate, the fins being in between, e.g. separated by and located in between, the STI regions or structures (see Fig. 11).

It is an advantage of the present disclosure that the layers grown are thinner (between 100 and 500nm) compared to the techniques used in prior art (SRB layers are typically 1µm thick). The layers are only grown on the patterned active part of the wafer (about 20-25% of the wafer area), which means the equivalent growth of the group III-V or Group IV semiconductor material is 10 to 50 times less compared to the use of SRB layers as is done in prior art. This has the advantage that manufacturing becomes less expensive as less group III-V or Group IV semiconductor material is used.

It is a further advantage of the present disclosure that defectivity in the active area is better compared to the defectivity level using SRB layers.

As the channel region is on a buried oxide layer and thus no buffer layer is used below the channel region as in prior art, a potential leakage path is not present.

## Claims

1. A method for manufacturing semiconductor-on-insulator devices, the method comprising:
- providing a pre-patterned donor wafer, comprising:
∘ providing a donor substrate (100) comprising a first semiconductor material;
∘ forming in the donor substrate shallow trench isolation (STI) regions (101);
∘ forming fins (103,105) in between the STI regions (101), the fins (103,105) being separated by the STI regions (101); a top part of the fins (105) comprising Group III-V or Group IV semiconductor material being different from the first semiconductor material,
- forming a first oxide layer (201) overlying the shallow trench isolation (STI) regions (101) and the fins (103,105);
- providing a handling wafer (2, 110, 211);
- bonding the pre-patterned donor wafer to the handling wafer (2) by contacting the first oxide layer to the handling wafer;
- removing at least part of the first semiconductor material of the pre-patterned donor wafer (2); and
- thinning the STI regions (101) and the fins (103,105) thereby forming channel regions comprising the Group III-V or Group IV semiconductor material.

2. A method for manufacturing semiconductor-on-insulator devices according claim 1, wherein forming the fins (103,105) comprises, after forming the STI regions (101), recessing part of the first semiconductor material in between the STI regions (101) and epitaxially growing the Group III-V or the Group IV semiconductor material in the recesses (106) using aspect ratio trapping (ART).

3. A method for manufacturing semiconductor-on-insulator devices according to claim 1 or 2, further comprising after thinning also removing the remainder of the STI regions (101).

4. A method for manufacturing semiconductor-on-insulator devices according to any of the previous claims, wherein providing a handling wafer (2) comprises providing a handling substrate (110) comprising a second semiconductor material covered with a second oxide layer (211).

5. A method for manufacturing semiconductor-on-insulator devices according to any of the previous claims, wherein the donor substrate is a blanket Si wafer.

6. A method for manufacturing semiconductor-on-insulator devices according to any of the previous claims, wherein the handling substrate (2) is chosen from a blanket or patterned Si wafer, a blanket or patterned Ge wafer, a blanket or patterned SOI wafer, a blanket or patterned germanium-on-silicon wafer, a blanket or patterned GeOI wafer.

7. A method for manufacturing semiconductor-on-insulator devices according to any of the previous claims, wherein the donor wafer and the handling wafer have the same wafer size, the wafer size being at least 300mm.

8. A method for manufacturing semiconductor-on-insulator devices according to any of the previous claims, wherein the Group III-V semiconductor material is chosen from InP, GaAs, InAs, AlAs, GaSb, AlSb, InSb and all ternary and quaternary combinations thereof or wherein the Group IV semiconductor material is chosen from Ge or SiGe.

9. A method for manufacturing semiconductor-on-insulator devices according to any of the previous claims, wherein removing at least part of the first semiconductor material comprises first removing the first semiconductor material present above the STI regions (101) followed by second removing the remaining first semiconductor material present between the STI regions (101).

10. A pre-patterned donor wafer for manufacturing a semiconductor-on-insulator device, comprising
- a donor substrate comprising a first semiconductor material;
- a pattern of shallow trench isolation (STI) regions (101) and fins (103,105) on the donor substrate; the fins (103,105) being separated by and located in between the STI regions (101); the fins comprising at least an upper part of a Group III-V or a Group IV semiconductor material being different of the first semiconductor material, and
- a first oxide layer (201) overlying the pattern.

11. A pre-patterned donor wafer according to claim 10, wherein the donor substrate is a blanket Si wafer with a wafer size of at least 300 mm.

12. A pre-patterned donor wafer according to claim 10 or 11, wherein the Group III-V semiconductor material is chosen from InP, InGaAs, InAs, GaAs, GaAsSb or wherein the Group IV semiconductor material is chosen from Ge or SiGe.

13. A pre-patterned donor wafer according to any of claim 10 to 12, wherein the at least upper part of the fins (103,105) has a defectivity level lower than 10⁶ defects/cm².

14. A pre-patterned donor wafer according to any of claim 10 to 13, wherein a bottom part (103) of the fins (103,105) comprises the first semiconductor material.

15. A semiconductor-on-insulator wafer, comprising a semiconductor substrate (110), an oxide layer (211, 201) on the substrate, and a pattern of fins (105) and STI (101) structures on the oxide layer, the fins (105) comprising a Group III-V or a Group IV semiconductor material different from the semiconductor substrate, the fins (105) being in between, e.g. separated by and located in between, the STI regions or structures (101).
